# EUROPEAN PATENT APPLICATION

(11) **EP 1 467 314 A1**
(43) Date of publication of application: **13.10.2004**
(21) Application number: 03252284.9
(22) Date of filing: 10.04.2003
(51) Int. Cl.: G06K 19/077, G06K 19/067

(54) **RFID tag comprising a battery and an antenna sharing common elements**

(71) Applicant: BTG INTERNATIONAL LIMITED, London EC4M 7SB (GB)
(72) Inventor: Turner, Christopher Gordon Gervase, Oakley, HP18 9QN (GB)
(74) Representative: Johnson, Reginald George

(57) **Abstract**

An RFID tag has a battery structure (31, 50, 60 ) and an antenna structure (31, 32 ) each sharing at least one common element (31) in order to minimise or eliminate the disadvantages normally associated with attaching a battery to a tag. A radio communication system comprising a reader and a plurality of RFID tags, and a method of fabricating the RFID tags are also described.

## Description

### FIELD OF INVENTION

This invention relates to radio (wireless) communication systems and more particularly to wireless communication systems using passive backscatter modulation technology. The invention also relates to an RFID tag and a method of fabrication.

### BACKGROUND TO THE INVENTION

Radio Frequency Identification (RFID) systems are used for the identification and tracking of objects, people, goods and living things. RFID systems usually, but not always, comprise a reader also known as an interrogator and a plurality of transponders, usually called tags, which are attached to, integrated into or carried by the object to be identified and tracked. The reader in an RFID system will be a transceiver incorporating a transmitter and a receiver. The transmitter is used to send commands or data to tags; the receiver being used to receive and decode messages from one or more tags. Additionally if a tag does not have its own internal power source, the reader's transmitter energy field is used by the tag to provide power for its internal circuits. There are two main types of tag, those that have a transmitter in the tag to generate a transmitting signal which is in turn modulated with the tag's data and there are those tags that do not have their own transmitter but make use of the signal impinging on the tag's antenna from the reader, by modulating the incident signal with the tag's data and simultaneously reflecting it back towards the reader. This method of communication is known as backscatter modulation and follows the principles of radar. The way a passive backscatter system works is: Communication originates when the reader switches on its transmitter and radiates an unmodulated continuous wave (CW) signal. In systems employing a method known as 'tag talks first' any tags receiving the energising signal will power up their internal circuits and respond by transmitting a message either once or repeatedly, by modulating the incident CW signal from the reader and reflecting this signal back out to be received by the reader's receiver. In systems employing a method known as 'reader talks first', on receiving the CW signal from the reader, tags will power up their internal circuits and wait for a further command from the reader; the reader then sends out a command or wake-up instruction which tells any tags recognising the command to transmit their messages. After the reader has finished transmitting its modulated wake-up, command or other signal, it then reverts to sending a CW signal which is in turn backscatter modulated by the tags with their data. It can be seen from this description that systems using passive tags make use of the signal transmitted by the reader for three distinct functions; to provide energy for the tags to power their internal circuits, as a carrier on which to modulate and reflect back a data message and as a communication means from reader to tag. It will be appreciated by those skilled in the art, that integrated circuit technology of the type used in RFID tags requires a supply voltage of typically 1.2 to 1.5 Volts at a current in the order of 3 to 5 microAmpres. In order to recover this amount of energy from the reader's energising field, a signal strength in the order of 5 to 10 Volts per metre is required at a tag's antenna. At UHF frequencies in the region of 900MHz, the reader would need to radiate 4 Watts of transmitter power to obtain a reading range of 2 to 3 metres. In some countries such as the USA and Canada, the radio regulations permit this sort of radiated power. However in other countries, notably in Europe, radiated power is restricted to 0.5 Watts or less, which in turn results in greatly reduced operating range. In order to overcome this problem battery assistance could be provided on a tag to provide the power for the tag's circuits, while still relying on the incident CW signal from the reader to provide the carrier on which tag's data message can be modulated using backscatter modulation. Backscatter modulation requires a signal strength of about one tenth that needed for energising the tag, so if tags were equipped with batteries an operating range using 0.5 Watts erp (effective radiated power) in Europe would be similar to the operating range obtained in the USA using 4 Watts eirp (effective radiated power with respect to an isotropic source) without battery assistance. Some major benefits to using passive, reader powered backscatter modulated tags, include; the extremely low cost of production, the ecologically friendly materials that can be used to construct tags and the ability to embed tags in thin and flexible labels and packaging. Adding a battery of contemporary design to a tag requires much more expensive manufacturing techniques and materials, also the battery is not easily disposed of, resulting in stringent disposal or recycling methods when tags are no longer needed or have reached the end of their useful life. Lithium batteries are bulky and add to the size and thickness of tags, limiting their use in disposable applications. Incorporating current Lithium or other similar battery technology into tags precludes the use of this type of tag in applications such as those where a tag is embedded in printed labels of the type used for bar codes or where tags need to be flexible for attachment to, or embedding in flexible packaging material. Recently several companies have started to produce printed or disposable batteries intended for the toy and medical electronics industries. These batteries are presently available in primary (non-rechargeable) form from Power Paper Ltd of Israel. There are several benefits to using the new battery technology. The most significant benefits are; the very low cost of printing the battery and; the environmentally friendly materials used in the process. There are no hazardous materials and batteries can be disposed of in normal domestic waste. Tags incorporating this battery technology making them battery assisted, offer useful operating range in those parts of the world such as Europe which have restrictions on reader power output and tight controls on the disposing of waste. They provide a viable alternative to passive backscatter modulated tags which require higher reader power output. It should also be pointed out, that even though higher transmitted RF power is presently permitted in the USA, it is considered 'good neighbourliness' to use only as much radiated power as necessary to do the job. Any method which can reduce the radiated transmitter power will have a positive impact on other users of the radio frequency spectrum. In order to incorporate printed batteries into RFID tags, an area of a square centimetre or more is required to accommodate a battery of sufficient energy capacity to power the tags for a working life of two or more years using the latest integrated circuit technology. A further hurdle to be overcome when incorporating batteries into tags, is the detuning or shielding effect that the battery has on the tag's antenna. The larger the conductive area of the battery, the greater will be the effect of the battery on the antenna. If this technology is used for induction coupled tags operating in the HF (13.56 or 6 MHz ) bands or in the LF (120 to 132kHz) bands, then the printed battery can be physically placed where it has little effect on the tag's antenna system. However, if this printed battery technology is incorporated into a VHF, UHF or microwave tag, then the battery, because of its size and composition, will unacceptable interfere with the normal antenna structure or its operating efficiency.

### OBJECT OF THE INVENTION

It is the object of this invention to at least alleviate the disadvantages of the present systems, and those systems which may benefit from the addition of a battery, namely;
the detrimental effect of incorporating a battery, on the physical characteristics, (such as flexibility, size and disposability) of the tag and;
the interference caused to the electrical and radio characteristics of the tag and its antenna which occurs when a battery is attached to a tag.

### SUMMARY OF THE INVENTION

According to one aspect of the invention, there is provided a method of fabricating an RFID tag in which a battery structure (of either primary, non-rechargeable or secondary, rechargeable characteristic) and antenna structure are integrated, or the battery and antenna share one or more common elements in order to minimise or eliminate the disadvantages of attaching a battery to a tag.

Another aspect of the invention is the provision of an RFID tag in which a battery structure (of either primary, non-rechargeable or secondary, rechargeable characteristic) and antenna structure are integrated, or the battery and antenna share one or more common elements in order to minimise or eliminate the disadvantages of attaching a battery to a tag.

Yet a further aspect of the invention is a radiocommunication system comprising a reader and plurality of RFID tags, at least one of the tags having a structure as hereinbefore defined.

### DESCRIPTION OF THE INVENTION

RFID tags usually (but not always) comprise an antenna which is formed of conductors; printed, plated, deposited or etched on a non-conductive substrate which may be flexible or rigid; to which is attached by means of solder or adhesives an electronic integrated circuit and optionally additional peripheral components. The antenna and integrated circuitry may also be formed on the integrated circuit itself, or spread over several insulating or semiconductor substrates. The conductors may be in the form of a dipole, loop, coil, zig-zag or patch antenna of types well known in the art. The antenna elements serve to collect radio frequency energy from the environment and conduct the energy to the integrated circuit, and to provide communication between the tag and the reader. The integrated circuit may have an external connection from its internal DC circuits to which a battery or other power source may be connected in order to provide the power necessary to operate the integrated circuit's internal circuits. This invention may be applied to many tags of existing design. It makes use of the antenna conductor or a part of the antenna conductor as a first pole of a battery. A spacer is then formed or printed over the conductor onto which is attached a second pole of the battery. The shape and form of the second pole is substantially similar, but need not be identical, to that of the first pole, furthermore the connecting conductor used to connect the second pole of the battery follows and is juxtaposed the antenna connecting conductor separated by an insulating spacer as it is routed to the integrated circuit. Because the radio frequency impedance between the antenna common [ground] connection and the DC input connection to the integrated circuit is low and provided that the connecting track between the antenna circuit and the integrated circuit (also being connected to the first pole of the battery) and the connecting track between the second pole of the battery and the integrated circuit follow the same path and are juxtaposed, there will be little effect on the operation of the antenna circuit, indeed the battery will be effectively "invisible" to the radio frequency characteristics of the antenna. In other words the electrical characteristics of the antenna will be almost the same as if the battery was not present.

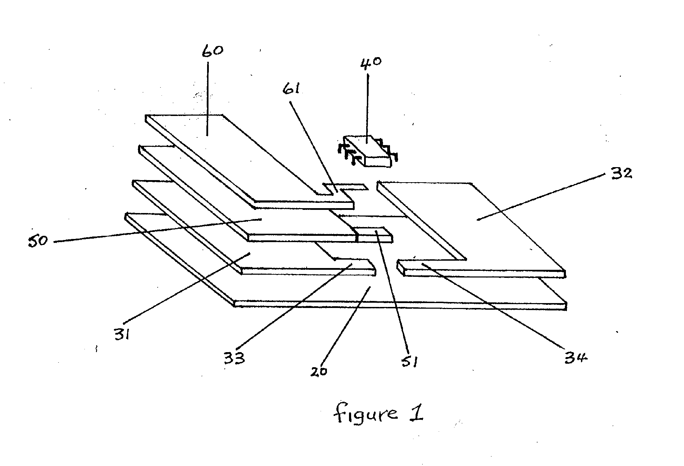

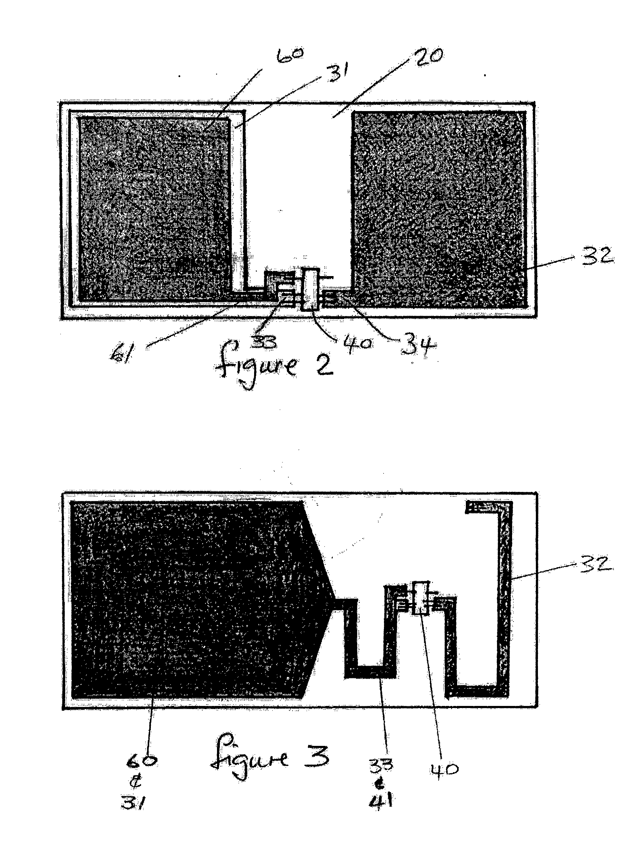

Refer now to figure 1. Figure 1 shows a UHF RFID tag 10, in the form of a rectangle approximately 80 by 55 millimetres. The base or substrate 20, of the tag is made from an insulator material such as fibre glass printed circuit stock, flexible plastic such as PET or paper. Attached to the substrate is an electrically conductive pattern, 31 & 32, which may be formed by attaching copper or aluminium foil to the substrate, or by using an etching process of the type used to make electrical printed circuit boards, or by printing the pattern on the substrate using a conductive ink, or by depositing a conductive material in the form of the required pattern. The transponder integrated circuit 40 is attached to the circuit using a known attachment method and the connections of the integrated circuit are electrically connected to the conductive pattern forming the antenna. The antenna pattern is divided into two parts 31 and 32 to form a dipole antenna. Pole 31 of the dipole antenna is connected to the antenna common [ground] pin of the integrated circuit 40 by means of a connecting track 33, the other pole 32 is connected to the antenna input pin of the integrated circuit by a similar connecting track 34. A spacer 50 which also contains the electrolyte for the battery is layed or printed over the conductive pattern 31, such that the conductive pattern is at least partially covered. An insulator 51, is either layed over or printed onto the conductive connecting track 33 which connects the pole 31 to the integrated circuit 40, such that the connecting track is completely covered except at the point where the track connects to the integrated circuit. A second pole 60 of the battery is formed by attaching a conductive plate or printing a conductor onto the surface of the spacer 50 and insulator 51. Connecting conductive track 61, is of substantially the same shape and form as the connecting track 33 and insulator 51, is in register with the insulator 51 and connecting track 33, and connects to the DC input pin of the integrated circuit 40. The complete tag assembly is finally coated with a non-conductive protective coating. Figure 2 shows the complete tag assembly. Figure 3 shows another embodiment using a tag having an off-centre fed antenna.

It will be appreciated that the invention can be applied to tags having almost any form or shape without limitation to size, shape or operating frequency except that there must be an adequate area of antenna conductor to form at least one pole of a battery. The invention may also be applied to RFID devices in which the antenna is incorporated on or into the integrated circuit. Many tag designs from companies such as Intermec, BiStar, SCS and Micron can be adapted to use this invention.

## Claims

1. An RFID tag in which a battery structure and an antenna structure are integrated by sharing one or more common elements.

2. An RFID tag as claimed in claim 1, in which the battery structure and antenna structure are fully integrated.

3. An RFID tag as claimed in claim 1 or 2, wherein the battery structure has a primary, non-rechargeable characteristic.

4. An RFID tag as claimed in claim 1 or 2, wherein the battery structure has a secondary, rechargeable characteristic.

5. An RFID tag as claimed in any one of claims 1 to 4, wherein the antenna structure is formed of conductors printed, plated, deposited or etched on a non-conductive substrate which may be flexible or rigid.

6. An RFID tag as claimed in claim 5, wherein an antenna conductor or a part of the antenna conductor defines a first pole of the battery structure.

7. An RFID tag as claimed in claim 6, wherein a spacer is layed or printed over the antenna conductor or the part of antenna conductor, a second pole of the battery being attached to the spacer on the opposite side to the conductor.

8. An RFID tag as claimed in claim 7, wherein the shape and form of the second pole of the battery is substantially similar or identical, to that of the first pole of the battery.

9. An RFID tag as claimed in claim 8, comprising a connecting conductor connecting the second pole of the battery to an integrated circuit, the connecting conductor substantially following and opposite another connecting conductor connecting the first pole of the battery to the integrated circuit, the two connecting conductors separated by an insulating spacer.

10. An RFID tag as claimed in any one of claims 7 to 9, wherein the spacer contains the electrolyte for the battery.

11. An RFID tag as claimed in claim 9 or claim 10, wherein the antenna structure has a pattern divided into two parts defining a dipole antenna, one pole of the antenna connected to a common(ground) pin of the integrated circuit and the other pole of the antenna connected to the input pin of the integrated circuit.

12. An RFID tag as claimed in claim 11 wherein connecting conductors or tracks connecting the poles of the antenna to the integrated circuit are of similar shape.

13. An RFID tag as claimed in claim 11, wherein the antenna is an off-centre fed antenna.

14. A radiocommunication system comprising a reader and plurality of RFID tags, at least one of the tags having a structure as claimed in any one of claims 1 to 13.

15. A method of fabricating an RFID tag, comprising the step of integrating at least part of an antenna structure for use as part of a battery structure.

16. A method of fabricating an RFID tag as claimed in claim 15, wherein the battery structure is of either primary, non-rechargeable or secondary, rechargeable characteristic.

17. A method of fabricating an RFID tags claimed in claim 15, the RFID tag fabricated having the structure defined in any one of claims 1 to 13.
